(19) Europäisches Patentamt
European Patent Office
Office européen des brevets

(11) **EP 1 944 266 A1**

(12) **EUROPEAN PATENT APPLICATION**

(43) Date of publication:
**16.07.2008 Bulletin 2008/29**

(51) Int Cl.:
***B81B 7/00*** *(2006.01)*

(21) Application number: **08100173.7**

(22) Date of filing: **08.01.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **10.01.2007 EP 07100340**

(71) Applicant: **Infineon Technologies SensoNor AS 3192 Horten (NO)**

(72) Inventors:
• **Kvisteroy, Terje**
  **3181, Horten (NO)**
• **Westby, Eskild**
  **N-3191, Horten (NO)**

(74) Representative: **Haley, Stephen**
  **Gill Jennings & Every LLP**
  **Broadgate House**
  **7 Eldon Street**
  **London EC2M 7LH (GB)**

(54) **MEMS Packaging with reduced mechanical strain**

(57)    A micro-electromechanical device comprises a micro-electromechanical die (20), a package (10), and three pillars (1; 2; 3) attaching the micro-electromechanical die to the package, least one of the shape, position and orientation of the pillars is such that any strain transferred from the package to the die by deformation of the package is minimised.

FIGURE 1

EP 1 944 266 A1

**Description**

The present invention is directed to an improved design for Micro Electro-Mechanical Systems (MEMS) packages. More specifically, the present invention is directed to improvements in how a MEMS die is attached to a package.

A MEMS die or die assembly which is attached to a package such as a lead frame, substrate or header, will experience mechanical stresses/strains due to a mismatch in the thermal expansion of the materials. These stresses can damage the die or indeed the package to which the die is attached and degrade the MEMS's performance. These stresses/strains will cause very sensitive and precise connections between the MEMS die and the package to become misaligned, thereby creating error signals and various types of malfunctions.

To remedy this problem, long and thick support structures such as thick support dies or long glass tubes have been developed. Unfortunately, these solutions require that the packages themselves be much larger and that the resulting wafer be considerably thicker.

Recently, dies have been introduced where the dies themselves form the support structure. These die supports are patterned or etched on one side of the main die using standard photolithography and wet or dry etching methods to form one or more pillars or pedestals. These smaller contact surfaces act as stress relief members by their ability to deform and thereby cause reduced stresses into the active part of the MEMS device.

Thus, what is needed is a MEMS design which comprises support pillars that, under the strain of deformation of a package, will minimise the strain which is transferred to the MEMS die.

In order to solve the problems associated with the designs of the prior art, the present invention provides a micro-electromechanical device comprising:

a micro-electromechanical die;
a package; and
three pillars attaching the micro-electromechanical die to the package, wherein:

at least one of the shape, position and orientation of the pillars is such that any strain transferred from the package to the die by deformation of the package is minimised.

With the arrangement of the present invention it is possible to instruct a MEMS device which has a minimal amount of stress and/or strain applied to the actual device both during manufacture and during operation yet which is still simple and cost effective to manufacture.

An example of the present invention will now be described with reference to the accompanying drawings in which:

Figure 1 represents a flow chart of the method of the present invention;
Figure 2 represents a side and bottom view of the pillar arrangement in accordance with one embodiment of the present invention;
Figure 3 represents the radial expansion model of a die and a package;
Figure 4 represents a 3-dimensional view of a pillar arrangement in accordance with the present invention;
Figure 5 represents a planar view of the spacial arrangement of pillars in accordance with the present invention; and
Figure 6 represents a planar view of radial an tangential forces induced in pillars in accordance with the present invention.

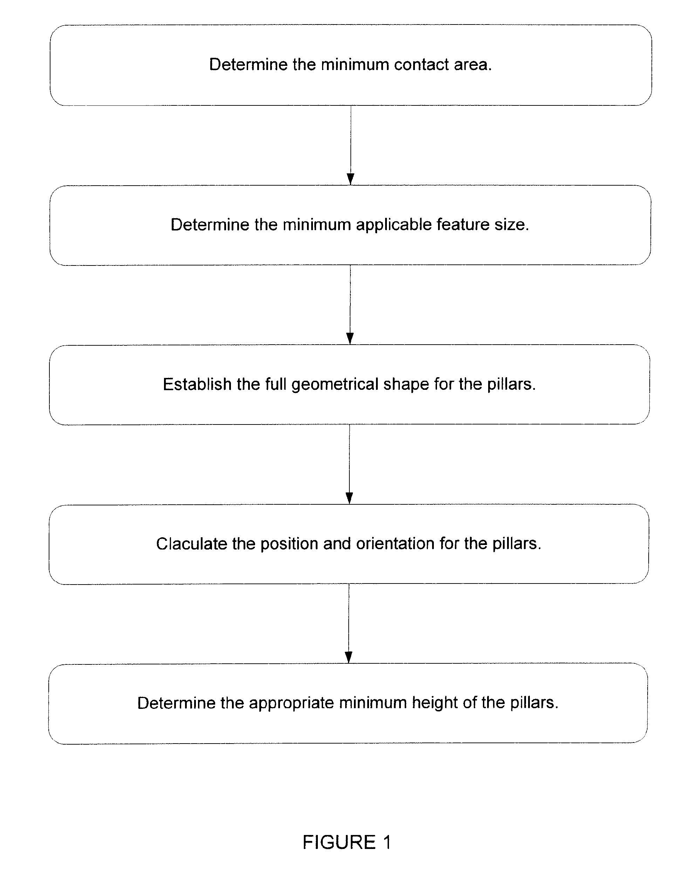

In reference to Figure 1, the present invention provides a method of minimizing the strain transferred from a package to a MEMS die. The first step of this method comprises selecting the minimum contact area (bond area), given the substrate material, die material and bond material and the bonding process in accordance with die shear (strength) test criteria. Such criteria can be found in standards like Mil-Std-883 Method 2019.

Die Shear Testing is the process of determining the strength of adhesion of a semiconductor die to the package's die attach substrate (such as the die pad of a lead frame or the cavity of a hermetic package), by subjecting the die to a stress that's parallel to the plane of the die attach substrate, resulting in a shearing stress between the die-die attach material interface and the die attach material-substrate interface.

The general purpose of die shear testing is to assess the over-all quality of the die attach process, including the integrity of the materials and the capabilities of the processes used in mounting the die (and other elements, if any) to the package substrate. Mil-Std-883 Method 2019 is the most widely-used industry standard for performing this test.

A typical die shear tester consists of: 1) a mechanism that applies the correct load to the die with an accuracy of +/- 5% of full scale or 50 g (the greater of these tolerances); 2) a die contact tool which makes the actual contact with the full length of the die edge to apply the force uniformly from one end of the edge to the other; 3) provisions to ensure that the die contact tool is perpendicular to the die attach plane; 4) provisions to ensure that the fixture holding the die may be rotated with respect to the contact tool so that the die edge and contact tool may always be aligned in parallel to each other; and 5) a binocular microscope (10X min magnification) and lighting system to facilitate the observation of the die and contact tool while the test is being performed.

The force applied to the die during die shear testing must be sufficient to shear the die from its mounting or twice the lower specification limit for the die shear strength (whichever occurs first). The direction of the applied force must be perpendicular to the die edge and parallel to the die attach or substrate plane. After the initial contact has been made and the application of force starts, the relative position of the tool must not change vertically (i.e. It must be prevented from contacting either the die attach material or the substrate).

Failures from die shear testing include: 1) failure to meet the specified die shear strength requirements; 2) a separation that occurs at less than 1.25X the minimum die shear strength and evidence of less than 50% adhesion of the die attach material; and 3) a separation that occurs at less than 2X the minimum die shear strength and evidence of less than 10% adhesion of the die attach material.

The mode of separation must also be classified into and recorded as any of the following: 1) shearing of the die itself with silicon remaining; 2) separation of the die from the die attach material; and 3) separation of both the die and die attach material from the package substrate.

The second step in the method comprises selecting the minimum applicable feature size for the footprint given the bonding process, the bond material and the bondline thickness.

For example, if the minimum bondline thicknesses are decided to be typically 10 micrometers, the minimum dimension to be supported of the bondline through the bonding process may be assumed to be 10x the bondline (i.e. 100 micrometers). The actual footprint (area of the pillars) must obviously support the die in the bonding material (non cured) and not push the material away, thereby not leaving any bondline thickness. The reason for establishing the minimum dimension (in one direction) is to position the most compliant direction of the pillar in the direction of maximum strain.

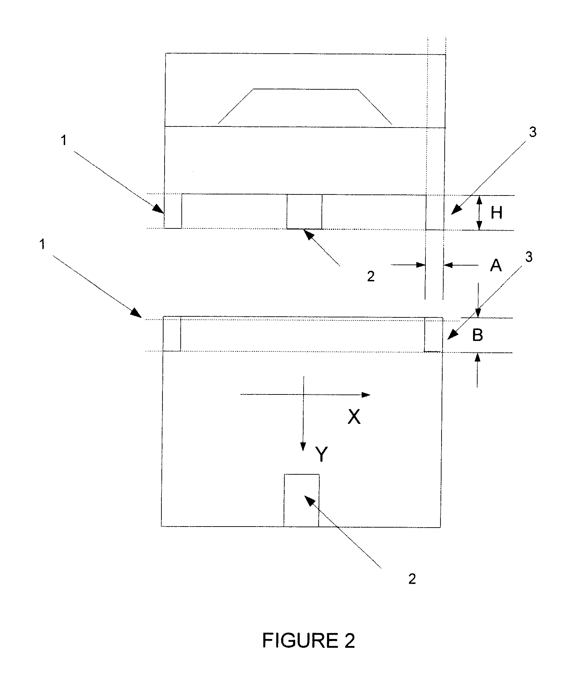

In reference to Figure 2, stress in the die, due to thermal or other effects causing mismatch in physical dimensions of the die in comparison to the substrate on which the die is mounted, will be proportional to the stiffness of the stands. According to general textbook formulas for stress & strain, the stiffness (k) in the stands will be:

$$\text{a) in case mismatch along X direction;} \quad k = \text{constant} \times (B \times A^3 / H^3)$$
$$\text{b) in case mismatch along Y direction;} \quad k = \text{constant} \times (A \times B^3 / H^3)$$

Typically, the minimum cross section A x B is given by the needed strength of the bonding technology used (gluing, anodic bonding, eutectic seal or similar). Therefore, optimum stress relief is by addressing the direction with the "worst" elongate mismatch and minimizing the thickness of the stand in this direction according to what is practically possible given the device and the manufacturing processes. Also, the height (H) of the stand should always be maximized according to what is practically possible given the device and the manufacturing processes.

The third step in the method comprises establishing the full geometrical shape for the pillars given the material and the shaping (manufacturing) process. The fourth step of the method comprises calculating the position of orientation.

In a first example of the fourth step of the present invention, the eaxmple problem of thermal expansion will be solved. Both the materials used for packages and the materials used for MEMS dies are subject to thermal expansion. Thermal expansion can be precisely modelled by selecting a point at the centre of a surface and assuming that the expansion of that surface extends radially from that point.

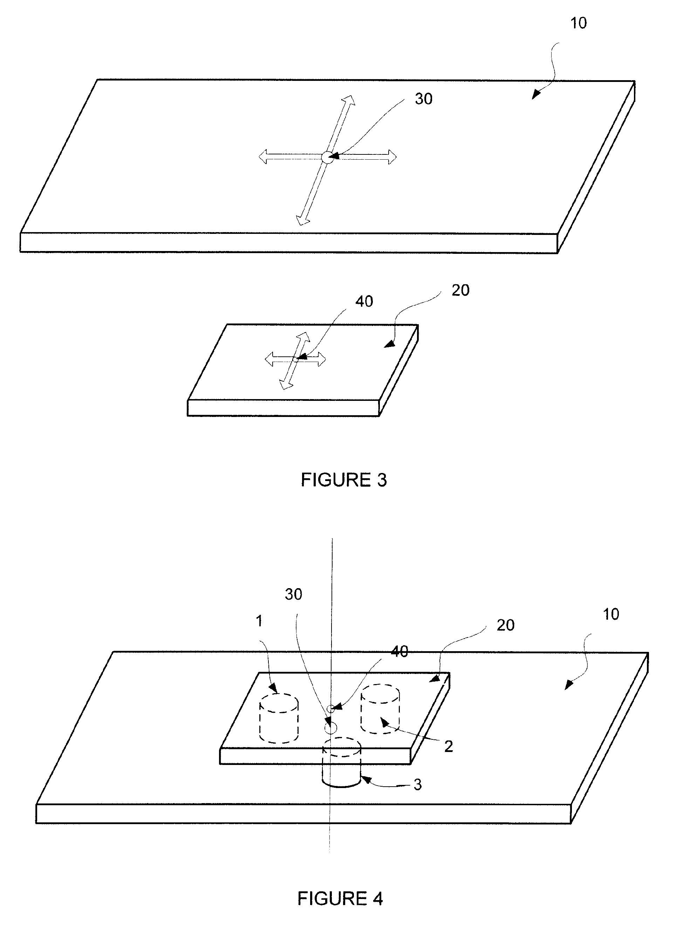

With reference to Figure 3, a package 10 has an origin 30 and a MEMS die 20 has an origin 40. The radial displacement (Δx) of a point around the origin of either the package 10 or the MEMS die 20 can be approximated by:

$$\Delta x = \alpha \bullet \Delta T \bullet r \qquad (1)$$

where $\alpha$ is the Coefficient of Thermal Expansion (CTE), $\Delta T$ is the change in temperature and r is the distance of a point from the origin. Thus, a point which is farther away from the origin will undergo a larger displacement than a point which is nearer to the origin.

In the majority of cases, a MEMS die 20 will not be made of the same material as the package 10 to which it is attached. Thus, typically, the MEMS die 20 and the package 10 will have different CTEs and will therefore be prone to varying degrees of thermal expansion. This creates a problem in that, because the MEMS die 20 is attached to the package 10, this difference in radial deformation will create a strain transferred by the pillars to the MEMS die 20 to the package 10.

The relative radial deformation of the package 10 with respect to the MEMS die 20 can be approximated by:

$$\Delta x_{rel} = (\alpha_{10} - \alpha_{20}) \bullet \Delta T \bullet r \qquad (2)$$

where r is the distance from the origine, $\alpha_{10}$ is the CTE of the package 10, $\alpha_{20}$ is the CTE of the MEMS die 20. Thus, relative deformation between the MEMS die 20 and the package 10 will create stress in the pillars in a radial direction. The applicant has appreciated that the pillars should be located as close to the origin as the stability of the die allows.

A problem which has been appreciated by the applicant is that, because of the anisotropic crystalline nature of the materials often used for the pillars, although the shearing forces acting on the pillars are all radial, these same radial forces will create tangential strains in the pillars, thereby applying tangential forces to the MEMS die 20.

Now, with reference to Figure 4, the applicant has also appreciated that the minimum number of pillars which will be needed to support a two dimensional surface is three (1; 2; 3). More than three pillars would unnecessarily complicate the method for balancing the forces acting upon the pillars. Also, in order to further simplify the calculations, for this example each pillar has the same shape and is orientated in the same way with respect to the origin. The calculations will be further simplified in that, because of the fact that the pillars are of identical shape and identical orientation with respect to the origin, the material properties of and the forces acting on each pillar can be expressed similarly using a distinct coordinate system for each pillar (i.e. $x_1$, $y_1$; $x_2$, $y_2$ and $x_3$, $y_3$).

Thus, the spring constant of any one of the pillars in the three pillar design of the present invention can be approximated by:

$$k_i = \begin{bmatrix} k_{x_i} & k_{xy_i} \\ k_{yx_i} & k_{y_i} \end{bmatrix} \qquad (3)$$

where i is the pillar number (i.e. 1 to 3), $k_x$ is the spring constant in the x direction, $k_y$ is the spring constant in the y direction, $k_{xy}$, is the spring constant in the x direction in relation to a force applied in the y direction and finally, $k_{yx}$ is the spring constant in the y direction in relation to a force applied in the x direction.

Now, using Hookes Law, it can be shown that the forces created in the pillars in response to a relative deformation of the MEMS die 20 with respect to the package 10 will be as follows:

$$F_i = k_i r_i \qquad (4)$$

or

$$F_i = \begin{bmatrix} k_{x_i} & k_{xy_i} \\ k_{yx_i} & k_{y_i} \end{bmatrix} \begin{bmatrix} \Delta x_i \\ \Delta y_i \end{bmatrix} \qquad (5)$$

However, since we assume that the deformation of the material is purely radial, $r_y$, the tangential displacement, will be 0. Thus, the product of these two matrices becomes:

$$F_i = -\begin{bmatrix} k_{x_i} \Delta x_i \\ k_{yx_i} \Delta y_i \end{bmatrix} \qquad (6)$$

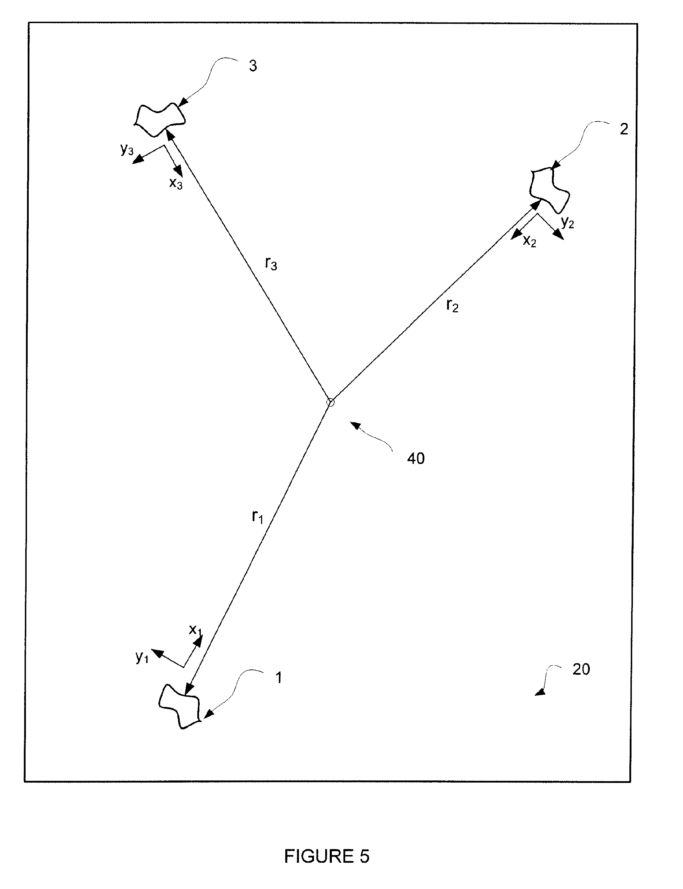

As shown in Figure 5, the force exerted by each pillar will have a radial component and a tangential component. The radial components will be $k_{xi} r_{xi}$ and the tangential components will be $k_{yxi} r_{xi}$.

The summation of forces gives:

$$k_{x_1} \Delta x_1 = -k_{x_2} \Delta x_2 \frac{\sin(\phi_2)}{\sin(\phi_1)} \qquad (9),$$

and

$$-k_{x_3} \Delta x_3 = k_{x_2} \Delta x_2 \cos(\phi_2) + k_{x_1} \Delta x_1 \cos(\phi_1) \qquad (10)$$

where, equations 9 represents the summation of forces in the $y_3$ direction and equation 10 represents the summation of forces in the $x_3$ direction. By combining equations 9 and 10 and replacing $\Delta x$ by $\alpha \cdot \Delta t \cdot r$, it can be shown that the summation of forces should be equal to:

$$k_{x_1} r_{x_1} = -k_{x_2} r_{x_2} \frac{\sin(\phi_2)}{\sin(\phi_1)} \qquad (11)$$

$$k_{x_3} r_{x_3} = k_{x_2} r_{x_2} \left( \frac{\sin(\phi_2)\cos(\phi_1)}{\sin(\phi_1)} - \cos(\phi_2) \right) \qquad (12)$$

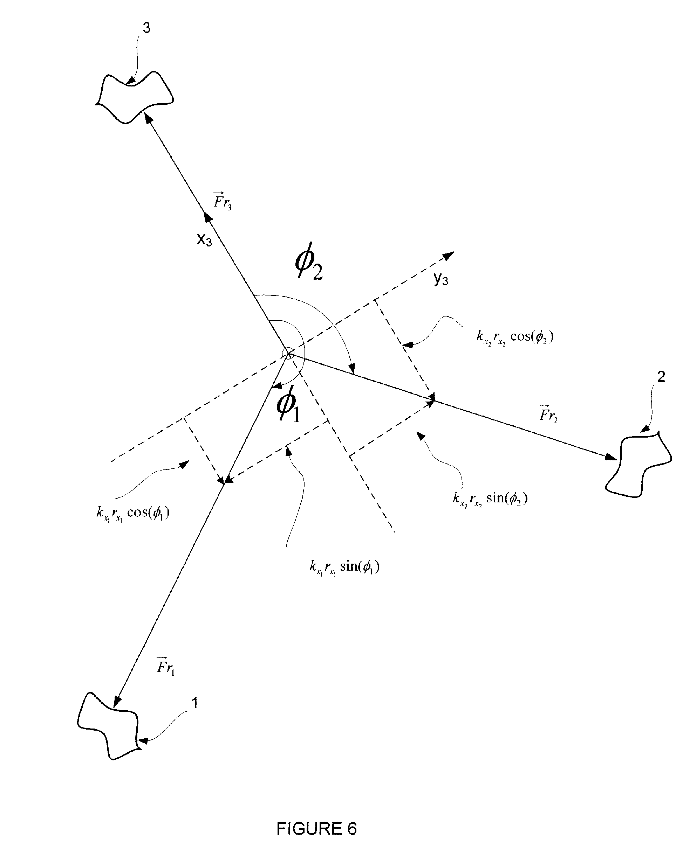

Now, again with reference to Figure 6 and equation 6, the sum of the tangential forces created by the three pillars will give rise to a moment:

$$\vec{M} = \sum_{i=1}^{3} r_i k_{yx_i} \Delta x_i \qquad (13)$$

As has been explained above, the tangential forces created in the pillars will be responsible for any rotational displacement of the MEMS die 20 with respect to the package 10. The moment relating the a tangential force in a pillar can be expressed as follows:

$$\vec{M}_i = \vec{F}_{Ti} \bullet r_{x_i} \qquad (14)$$

by combining equations 12 and 13, the sum of the moments can be expressed as follows:

$$\vec{M} = \sum_{i=1}^{3} k_{yx_i} \left( r_{x_i} \right)^2 \qquad (15)$$

If the sum of the moments relating to the tangential forces are equal to 0, there will be no rotational displacement of the MEMS die 20 with respect to the package 10. In order to completely eliminate the rotational movement of the MEMS die 20 relative to the package 10, the following equation must be true:

$$0 = \sum_{i=1}^{3} k_{yx_i} \left( r_{x_i} \right)^2 \qquad (16)$$

Thus, the material used in fabrication of pillars for MEMS dies 20 can be taken advantage of by positioning the pillars in order to satisfy the following equations:

$$k_{x_1} r_{x_1} = - k_{x_2} r_{x_2} \frac{\sin(\phi_2)}{\sin(\phi_1)} \qquad (17),$$

$$0 = \sum_{i=1}^{3} k_{yx_i} \left( r_{x_i} \right)^2 \qquad (18),$$

and

$$k_{x_3} r_{x_3} = k_{x_2} r_{x_2} \left( \frac{\sin(\phi_2)\cos(\phi_1)}{\sin(\phi_1)} - \cos(\phi_2) \right) \qquad (19).$$

By satisfying equations 17, 18 and 19, one can position and orient the pillars such that the strain transferred from the package to the die is minimised.

The final step in the method of the present invention is to calculate the appropriate minimum height (H) for the pillars according to the maximum allowed stress in relation to the die performance. For example, if a certain function has a calculated known sensitivity to stress in the die, using the pillar solution, this stress may be reduced by the compliance of the pillars. The capacity for the pillars to absorb stress will be inversely proportional to $H^3$.

## Claims

1. A micro-electromechanical device comprising:

   a micro-electromechanical die (20);
   a package (10); and
   three pillars (1; 2; 3) attaching the micro-electromechanical die to the package, wherein:

   at least one of the shape, position and orientation of the pillars is such that any strain transferred from the package to the die by deformation of the package is minimised.

2. The micro-electromechanical device of claim 1, wherein the pillars are bonded to the package and the shape of the pillars is determined based on the minimum contact area needed, given the package, the micro-electromechanical die and bond materials and the bonding process in accordance with die shear test criteria, as given in specific standards, such as Mil-Std-883 Method 2019.

3. The micro-electromechanical device of any of the preceding claims, wherein the shape of the pillars is also determined based on the minimum applicable feature size, given the bonding process, the bond material and the bondline thickness.

4. The micro-electromechanical device of any of the preceding claims, wherein the pillars are formed on the die using chemical etching or mechanical abrasion.

5. The micro-electromechanical device of any of claims 1 to 3, wherein the pillars are formed on the substrate using patterned electroplating, moulded pillars or mechanical stamping.

6. The micro-electromechanical device of any of claims 1 to 3, wherein the pillars are prefabricated and bonded onto the die.

7. The micro-electromechanical device according to any of the preceding claims, wherein,

the three pillars are arranged around a point on a surface of the mico-electromechanical die (20);

$r_{x1}$, $r_{x2}$ and $r_{x3}$ are the lengths of first, second and third axes extending from the first, second and third pillars (1; 2; 3) respectively to the point;

$k_{x1}$, $k_{x2}$ and $k_{x3}$ are the spring constants in the radial direction of the point of the first, second and third pillars (1; 2; 3) respectively;

$k_{yx1}$, $k_{yx2}$ and $k_{yx3}$ are the relationships between a deformation of the first, second and third pillars (1; 2; 3) respectively in a direction which is both normal to the radial direction of the central point and parallel to a plane formed by the surface of the micro-electromechanical die (20) and a force applied to the first, second and third pillars (1; 2; 3) respectively in radial direction of the point;

$\phi_1$ and $\phi_2$ are the angles separating the first and second axes respectively from the third axis; and

the position of the three pillars satisfy the following equations:

$$k_{x_1} r_{x_1} = -k_{x_2} r_{x_2} \frac{\sin(\phi_2)}{\sin(\phi_1)} \quad ;$$

$$k_{x_3} r_{x_3} = k_{x_2} r_{x_2} \left( \frac{\sin(\phi_2)\cos(\phi_1)}{\sin(\phi_1)} - \cos(\phi_2) \right) ;$$

and

$$0 = \sum_{i=1}^{3} k_{yx_i} \left( r_{x_i} \right)^2 .$$

Determine the minimum contact area.

Determine the minimum applicable feature size.

Establish the full geometrical shape for the pillars.

Claculate the position and orientation for the pillars.

Determine the appropriate minimum height of the pillars.

FIGURE 1

FIGURE 2

FIGURE 3

FIGURE 4

FIGURE 5

FIGURE 6

EP 1 944 266 A1

**European Patent Office**

**EUROPEAN SEARCH REPORT**

Application Number

EP 08 10 0173

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GB 2 253 739 A (BOSCH GMBH ROBERT [DE]) 16 September 1992 (1992-09-16) * figures 1a,1b,2a * * pages 1,2,4,5 * ----- | 1-7 | INV. B81B7/00 |
| A | WO 2006/019761 A (DRAPER LAB CHARLES S [US]; SAWYER WILLIAM D [US]) 23 February 2006 (2006-02-23) * figure 8 * * paragraph [0008] * ----- | 1-7 | |

TECHNICAL FIELDS SEARCHED (IPC)

B81B

The present search report has been drawn up for all claims

| Place of search | Date of completion of the search | Examiner |
|---|---|---|
| Berlin | 3 March 2008 | McGinley, Colm |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 08 10 0173

This annex lists the patent family members relating to the patent documents cited in the above-mentioned European search report.
The members are as contained in the European Patent Office EDP file on
The European Patent Office is in no way liable for these particulars which are merely given for the purpose of information.

03-03-2008

| Patent document cited in search report | | Publication date | Patent family member(s) | | Publication date |
|---|---|---|---|---|---|
| GB 2253739 | A | 16-09-1992 | DE | 4107658 A1 | 17-09-1992 |
| | | | JP | 5075176 A | 26-03-1993 |
| | | | US | 5273939 A | 28-12-1993 |
| WO 2006019761 | A | 23-02-2006 | AU | 2005275206 A1 | 23-02-2006 |
| | | | CA | 2573907 A1 | 23-02-2006 |
| | | | EP | 1779413 A2 | 02-05-2007 |

EPO FORM P0459

For more details about this annex : see Official Journal of the European Patent Office, No. 12/82